Europäisches Patentamt

(19) **European Patent Office**

**Office européen des brevets**

(11) Numéro de publication: **0 092 879**
**B1**

(12) **FASCICULE DE BREVET EUROPEEN**

(45) Date de publication du fascicule du brevet:
**26.08.87**

(21) Numéro de dépôt: **83200576.3**

(22) Date de dépôt: **21.04.83**

(51) Int. Cl.⁴: **H 04 L 7/02,** H 03 K 4/06

(54) **Dispositif de synchronisation bit pour modulateur-démodulateur ou récepteur de transmission de données.**

(30) Priorité: **28.04.82 FR 8207325**

(43) Date de publication de la demande:
**02.11.83 Bulletin 83/44**

(45) Mention de la délivrance du brevet:
**26.08.87 Bulletin 87/35**

(84) Etats contractants désignés:
**BE CH DE FR GB IT LI NL SE**

(56) Documents cités:
**CH - A - 552 305**
**US - A - 3 337 747**

**ELEKTRONIK, vol. 1, janvier 1980, Munich (DE); H. KÜMMEKE: "Steuerbarer Oszillator für zahlreiche praktische Anwendungen", pages 81, 82**

(73) Titulaire: **TELECOMMUNICATIONS RADIOELECTRIQUES ET TELEPHONIQUES T.R.T., 88, rue Brillat Savarin, F-75013 Paris (FR)**

(72) Inventeur: **Boudault, Robert, SOCIETE CIVILE S.P.I.D. 209 rue de l'Université, F-75007 Paris (FR)**

(74) Mandataire: **Pyronnet, Jacques et al, Société Civile S.P.I.D. 209 rue de l'Université, F-75007 Paris (FR)**

ACTORUM AG

### Description

L'invention concerne un dispositif de synchronisation bit (synchrobit) recevant, en mode de transmission asynchrone, des données sous forme de trains d'impulsions binaires qui présentent des transitions détectables entre des états binaires, chaque bit ayant la durée T, comportant un oscillateur qui engendre un signal de base de temps dont la fréquence libre est sensiblement égale au double du débit binaire desdits trains d'impulsions, comportant un détecteur de transitions qui délivre sur une première sortie une impulsion de tension positive calibrée en amplitude et en durée lors de chaque transition du signal de données, dans lequel ledit oscillateur fournit un signal de tension interne triangulaire à la fréquence dudit signal de base de temps et des moyens de correction de phase étant prévus entre la première sortie du détecteur de transitions et l'entrée dudit oscillateur pour modifier la pente dudit signal de tension interne dans le sens d'une variation unidirectionnelle, en valeur algébrique, pendant la durée de ladite impulsion calibrée.

Ce dispositif, utilisable dans un modulateur-démodulateur (Modem) et, de préférence, dans un récepteur de transmission de données, permet de fournir au Modem ou au récepteur un générateur d'horloge (signal de base de temps) synchrone des données reçues, sous forme d'un signal rectangulaire dont la transition positive peut être utilisée notamment pour l'échantillonnage du signal de données, ce qui permet de régénérer ce signal de données. L'invention s'applique de préférence à des transmissions à basse rapidité à fréquences vocales modulées, le débit binaire (rapidité de modulation) étant de préférence égal ou inférieur à 4800 bauds.

Une solution connue fréquemment adoptée pour obtenir la synchronisation bit en transmission asynchrone consiste à utiliser un dispositif de synchronisation bit numérique. Ce dernier dispositif est difficilement applicable au type de modem considéré car il nécessite l'utilisation d'une base de temps à quartz et de plusieurs circuits logiques et bascules. Une telle solution est performante, mais encombrante, complexe et peu économique pour le type d'application demandé; elle s'adresse en effet à des modems de haut de gamme (haute rapidité) pour lesquels on doit avoir, en vertu des normes du CCITT, une très bonne stabilité à l'émission (précision sur la fréquence, supérieure à 1200 bauds, de l'ordre de $10^{-4}$ et emploi de la technologie LSI) alors que l'invention s'adresse plutôt à des modems de basse et moyenne rapidité (inférieure ou égale à 4800 bauds) pour lesquels la base de temps à quartz peut être remplacée par un oscillateur RC, une précision sur la fréquence de 0,5% étant suffisante à la réception.

Le dispositif selon l'invention se caractérise par sa simplicité de réalisation alliée à une assez grande précision, étant cependant de conception entièrement analogique. On connaît des dispositifs de synchronisation bit analogiques pour transmission asynchrone en basse fréquence, notamment du brevet US 3 337 747 selon lequel le problème technique à résoudre est très proche de celui de la présente demande. Dans ce dernier brevet, deux chaînes de régulation sont nécessaires pour la synchronisation du signal de base de temps par rapport à chaque train de données, en cours de message, outre la chaîne de mise en phase autoritaire en début de message (synchronisation rapide), pendant la première impulsion: une première chaîne produit un signal (de tension) analogique représentatif de l'erreur de phase à corriger, à chaque période, et dont l'amplitude est une fonction croissante de cette erreur de phase. Ce signal est exploité pour corriger partiellement l'erreur de phase, dans le sens d'une réduction de cette erreur, réduction d'autant plus grande que ledit signal analogique a une amplitude élevée, c'est-à-dire d'autant plus grande que l'erreur de phase est importante. Il s'ensuit que le dispositif présente une faible inertie pour des déphasages grands et notamment pour la plupart des impulsions parasites dans le signal de données et une grande inertie pour des déphasages faibles, c'est-à-dire une mauvaise efficacité dans les deux cas puisque l'influence des impulsions parasites est peu atténuée et qu'une remise en phase rigoureuse des deux signaux n'est jamais obtenue (présence de vacillement, dit «jitter» en langue anglaise). On notera par ailleurs qu'une correction de phase systématique à chaque période du signal de base de temps implique de ce fait une correction de fréquence, ceci étant vrai d'une manière générale et notamment pour le dispositif du brevet US précité. Or, dans ce dernier brevet, la chaîne de correction de phase ne permet pas de maîtriser simultanément la phase et la fréquence puisqu'une deuxième chaîne de régulation de fréquence est toujours nécessaire. Cette deuxième chaîne se compose de moyens pour intégrer ledit signal analogique afin d'obtenir un deuxième signal représentatif du déphasage moyen détecté lors des transitions successives du signal de données, ce deuxième signal étant appliqué à l'oscillateur à l'effet de minimiser ledit déphasage moyen. La présence de cette deuxième chaîne complique singulièrement le dispositif et suscite des doutes quant à son bon fonctionnement. L'invention se propose de réaliser un dispositif de synchronisation bit analogique qui soit simple et économique sans préjudice de sa précision puisqu'il doit être applicable à des trains de données en transmission asynchrone présentant un débit binaire qui peut s'élever jusqu'à 4800 bauds.

Il est aussi connu, du brevet CH 552 305, un dispositif de synchrobit tel que défini dans le premier paragraphe de la présente description au moyen duquel ladite variation unidirectionnelle créée à l'occasion de chaque transition positive du signal de données est une augmentation. Le pas de correction ainsi créé est variable, ledit signal de tension interne triangulaire n'étant pas formé de segments de droite mais de segments courbés. Il en résulte un fonctionnement de ce dispositif qui ne procure pas une grande efficacité ni une grande inertie et un instant d'échantillonnage qui n'est pas optimal car éloigné du milieu du moment élémentaire.

Un but de l'invention est de réaliser un dispositif de synchrobit analogique dans lequel une seule chaîné de traitement de signal permet de réaliser un accrochage de phase précis, exempt de vacillement (ce qui implique par surcroît l'asservissement rigoureux en fréquence). Un autre but de l'invention est l'obtention d'un dispositif qui présente une grande inertie, quel que soit le déphasage, au moyen d'un pas de correction de valeur prédéterminée constante.

Les inconvénients de l'art antérieur sont évités et les buts indiqués ci-dessus sont atteints grâce au fait que le dispositif de synchrobit défini en préambule est remarquable en ce que ladite variation unidirectionnelle est une diminution de valeur prédéterminée apte à créer un pas de correction sous forme d'un retard prédéterminé constant (respectivement une avance prédéterminée constante) de phase lorsque ladite impulsion calibrée se produit lors d'une rampe positive (respectivement négative) dudit signal de tension interne triangulaire qui est formé de segments de droite et que la durée de chaque pas de correction, sensiblement égale à celle de ladite impulsion calibrée, soit faible devant la durée T d'un bit de façon que, avant l'obtention de la synchronisation, la correction n'agisse individuellement que sur la rampe positive (respectivement négative) dudit signal de tension interne triangulaire.

Selon un mode de réalisation préféré, l'oscillateur comporte un amplificateur opérationnel monté avec un condensateur relié à son entrée inverseuse pour former un circuit intégrateur dont la sortie est connectée à une bascule à seuil avec hystérésis fournissant un signal de base de temps sous forme d'une tension bivalente qui est appliquée à une borne d'une première résistance dont l'autre borne est à relier à l'entrée inverseuse dudit amplificateur opérationnel et le dispositif de synchrobit est remarquable en ce que ledit signal de tension interne triangulaire est obtenu à la sortie dudit amplificateur opérationnel et que lesdits moyens de correction de phase sont constitués par une deuxième résistance connecté entre ladite première sortie dudit détecteur de transitions et l'entrée inverseuse dudit amplificateur opérationnel et dont la valeur est du même ordre que celle de ladite première résistance.

Dans ce mode de réalisation, le détecteur de transitions comporte par exemple un circuit monostable et un injecteur de courant. Des corrections sont ainsi apportées à la charge ou à la décharge à courant constant du condensateur de l'oscillateur d'une manière telle que le temps de charge est augmenté d'un intervalle de temps prédéterminé lorsqu'une transition de la donnée intervient pendant la charge et le temps de décharge est diminué d'un intervalle de temps prédéterminé lorsqu'une transition de la donnée intervient pendant la décharge du condensateur. Le résultat de ces corrections de charge ou de décharge est de mettre sensiblement en coïncidence au bout d'un certain nombre de transitions de la donnée l'instant d'apparition d'une transition avec l'instant d'un front descendant de la sortie de l'oscillateur, ce qui correspond à la synchronisation désirée (phénomène de convergence). Le principal avantage de l'invention est sa simplicité de réalisation et d'utilisation.

Le dispositif de synchrobit permet le maintien de la synchronisation pendant la durée des messages. Or, l'intervalle de temps entre deux messages a une longueur aléatoire. Deux possibilités s'offrent alors pour obtenir la synchronisation en début de message:

– soit prévoir un préfixe de message comportant assez de transitions pour être sûr de l'accrochage de la synchronisation avant le début véritable du message (information proprement dite), auquel cas le dispositif de synchrobit indiqué ci-dessus convient;

– soit munir le récepteur d'un circuit assurant la remise en phase brutale en début de message dès la première transition, auquel cas il faut adjoindre au dispositif de synchrobit un circuit de synchronisation rapide.

Un autre avantage de l'invention est que le circuit de synchrobit analogique indiqué ci-dessus est compatible avec un circuit de synchronisation rapide analogique simple qui reçoit un signal DS (détection de signal de données), ainsi qu'un deuxième signal de sortie en provenance dudit détecteur de transitions et dont la sortie est constituée par deux conducteurs reliés aux bornes du condensateur de l'oscillateur.

La description qui suit en regard des dessins annexés, le tout donné à titre d'exemple, fera bien comprendre comment l'invention peut être réalisée.

La figure 1 est le schéma électronique fonctionnel d'un mode de réalisation de l'invention.

La figure 2 est un diagramme de temps permettant d'expliciter le fonctionnement de l'oscillateur connu utilisé.

La figure 3 est un diagramme de temps permettant d'expliciter le fonctionnement du détecteur de transitions utilisé.

La figure 4 est un diagramme de temps permettant d'expliciter le principe de fonctionnement du circuit de synchrobit selon l'invention.

Les figures 5, 6, 7, 8 et 9 sont des chronogrammes qui montrent le fonctionnement du circuit de synchrobit en fonction de diverses conditions initiales pour les signaux de données et de base de temps, en fonction des fréquences libres relatives de ces deux signaux, ou en présence d'une forme particulière du signal de données.

La figure 10 est le schéma électronique fonctionnel d'un circuit de synchronisation rapide adapté au circuit de synchrobit selon l'invention.

Les figures 11 et 12 sont des chronogrammes qui montrent le fonctionnement d'un premier mode de réalisation du circuit de synchronisation rapide de la figure 10.

La figure 13 est un chronogramme qui montre le fonctionnement d'un deuxième mode de réalisation du circuit de synchronisation rapide de la figure 10.

La figure 14 est un schéma électronique détaillé du mode de réalisation de la figure 1, avec circuit de synchronisation rapide.

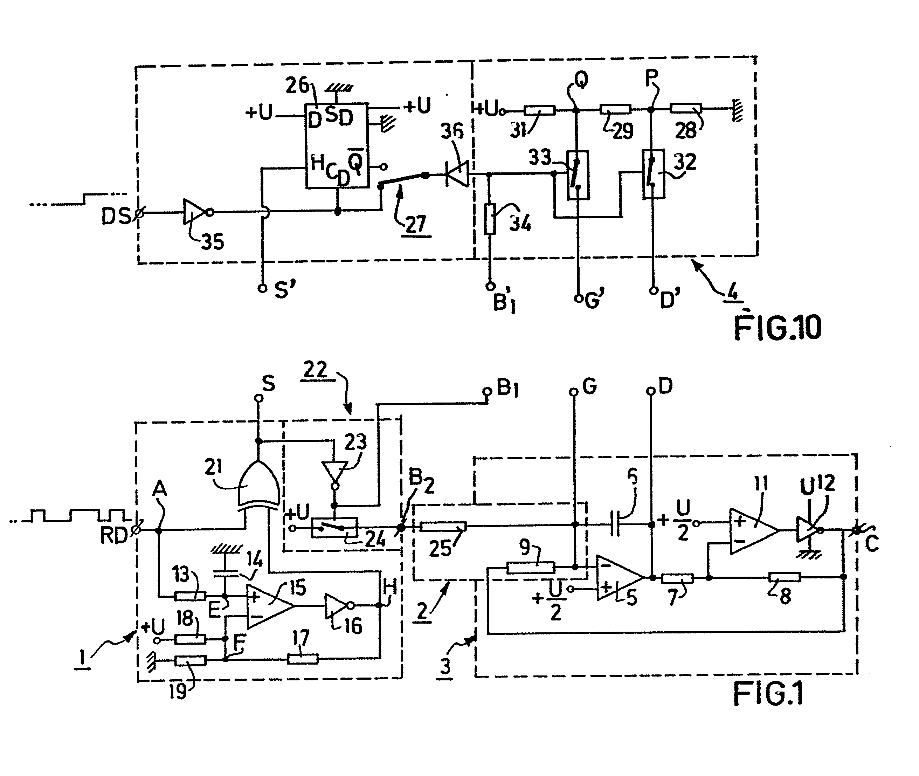

Sur la figure 1 est représenté un détecteur de transitions 1 qui reçoit un signal de données RD sous la forme de bits «1» ou «0» de durée T, ce signal RD étant le siège d'une tension +U pour les bits de valeur logique «1» et d'une tension nulle pour les bits de valeur logique «0». Une première sortie du détecteur 1 fournit à un correcteur de phase 2 un signal formé d'impulsions dont le front montant coïncide avec chaque transition du signal RD et dont la durée, de valeur prédéterminée Tx, constante en première approximation, est déterminée par le circuit monostable du détecteur 1. Le correcteur de phase 2 reçoit sur une deuxième entrée le signal de sortie C d'un oscillateur triangulaire 3 tel que décrit dans la demande de brevet français 2 453 536 au nom de la demanderesse ou le brevet US 4 039 952. La sortie du correcteur de phase 2 est rebouclée à l'entrée de l'oscillateur 3. Le correcteur de phase 2 est réalisé d'une façon originale qui constitue le cœur de l'invention.

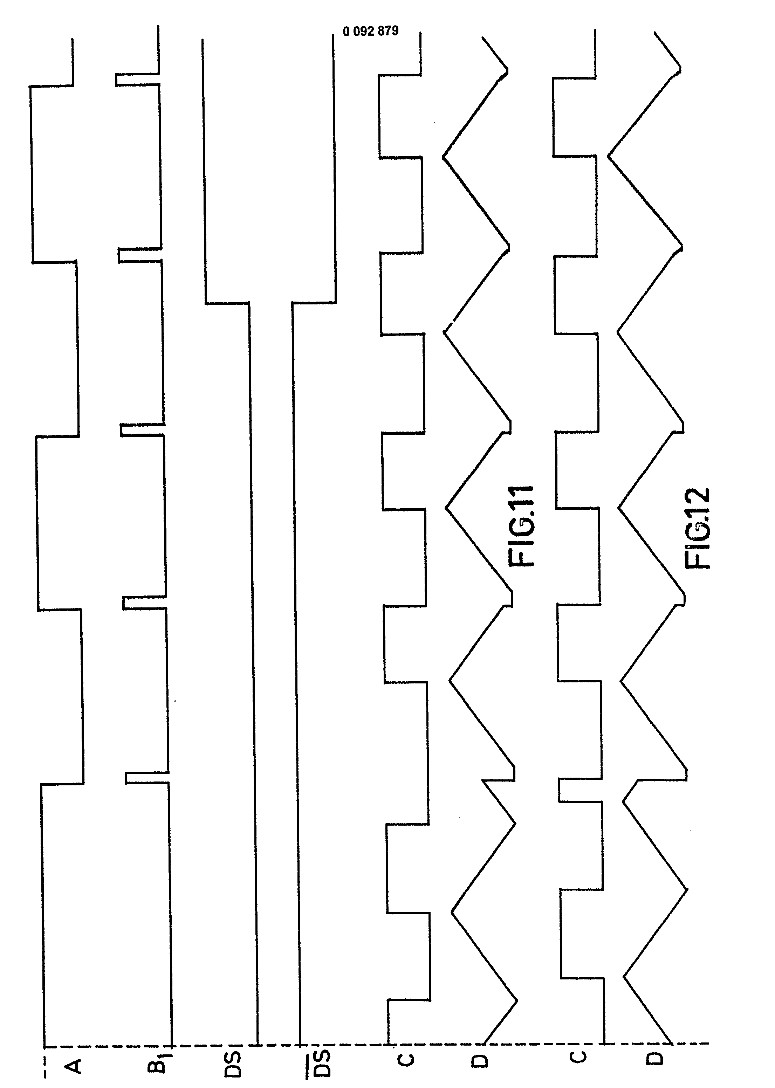

En regard de la figure 1 on a aussi représenté, figure 10, un circuit de synchronisation rapide 4, recevant le signal de détection de données DS sur une première entrée, une deuxième entrée, $B'1$, étant destinée à recevoir un deuxième signal de sortie, en B1, du détecteur 1. La sortie (double) du circuit 4 est reliée à une deuxième entrée (double) de l'oscillateur 3. Le signal DS porte la tension nulle en l'absence de données et la tension + U en présence de données. Le front montant du signal DS peut apparaître soit avant, soit après la première transition de chaque message (train) de données.

L'oscillateur 3 (figure 1) comporte un amplificateur opérationnel à grand gain 5, monté en intégrateur, un condensateur 6 de capacité $C_6$ étant branché entre son entrée inverseuse G et sa sortie D. La sortie D est rebouclée sur l'entrée inverseuse par le montage en cascade de trois résistances 7, 8 et 9 de valeurs respectives $R_7$, $R_8$ et $R_9$, la résistance 9 étant qualifiée de première résistance. La tension au point commun des résistances 7 et 8 est comparée à la tension U/2 dans un amplificateur opérationnel comparateur 11, suivi d'un inverseur 12. Les éléments 11 et 12 constituent une bascule à seuil avec hystérésis. La sortie C de l'inverseur 12, reliée au point commun entre les résistances 8 et 9, est alternativement le siège de la tension U ou 0. La présence de l'inverseur 12 se justifie par le fait que le comparateur 11 ne fonctionne pas de façon linéaire et que la tension en C doit être la plus proche possible de U ou de 0. Pour la description détaillée et le fonctionnement de l'oscillateur 3 on se reportera à la demande de brevet français 2 453 536.

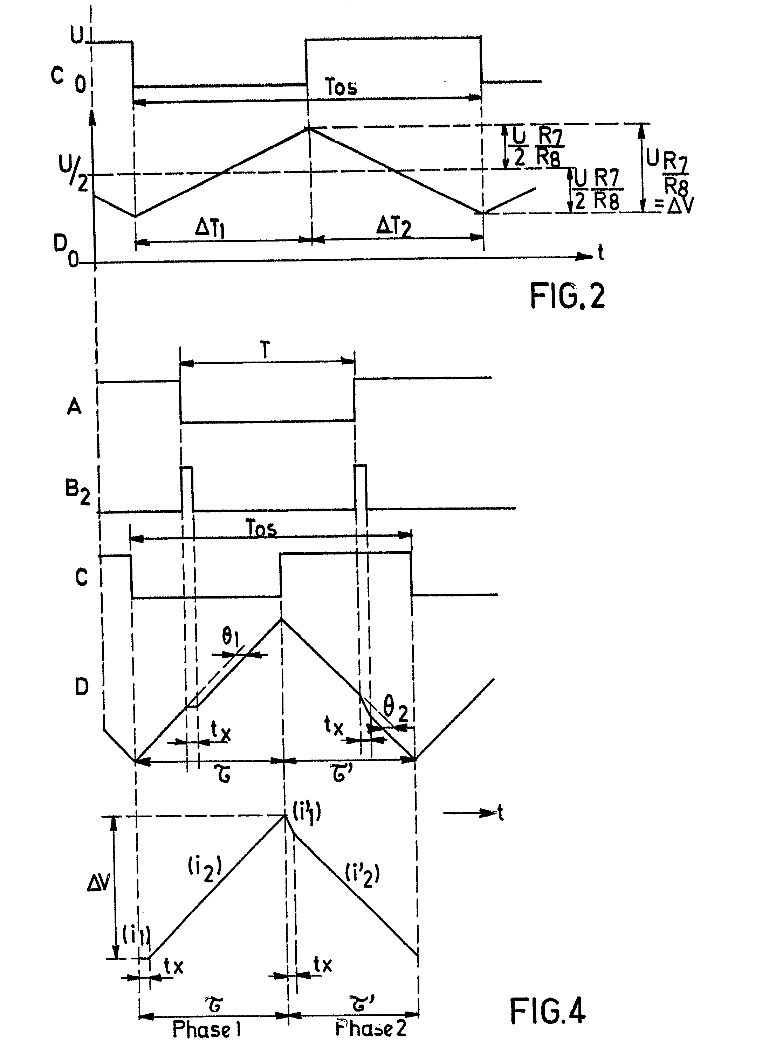

Le résultat du fonctionnement est indiqué par les diagrammes de temps de la figure 2: le point D est le siège d'une tension en dents de scie symétrique (triangulaire) centrée autour de U/2 et dont les rampes positive et négative ont la même pente en valeur absolue.

Soient:

| | |
|---|---|
| I | le courant qui traverse la résistance 9 dans l'un ou l'autre sens; |
| $\Delta V$ | l'excursion de tension de la dent de scie; |
| $F_{OS}$ | la fréquence de l'oscillateur ($F_{OS} = 1/T_{OS}$) |
| $\Delta T_1$, ou $\Delta T_2$ | la durée d'une rampe positive, ou négative, de la dent de scie ($\Delta T_1 = \Delta T_2 = \Delta t = T_{OS}/2$) |

On obtient:

$$\frac{I}{C_6 \, \Delta V} = \frac{1}{\Delta t} \text{ avec } \Delta V = U \frac{R_7}{R_8} \text{ et } I = \frac{U}{2R_9}$$

$$F_{OS} = \frac{1}{2\Delta t} = \frac{I}{2 \, C_6 \, \Delta V} = \frac{UR_8}{4 \, R_9 \, C_6 \, UR_7} = \frac{R_8}{R_7} \cdot \frac{1}{4 \, R_9 \, C_6}$$

On prend en pratique

$$\frac{R_8}{R_7} = 2$$

(rapport lié aux performances des amplificateurs opérationnels utilisés) ce qui entraîne:

$$F_{OS} = \frac{I}{2 \, R_9 \, C_6} = \frac{Y_9}{2C_6} \; (Y_9 = \frac{1}{R_9}) \quad \text{et}$$

$$T_{OS} = \frac{2C_6}{Y_9} \tag{0}$$

Le signal de sortie de l'oscillateur, au point C (voir figure 2) est un signal carré d'amplitude comprise entre 0 et U dont les front montants coïncident avec chaque fin de rampe positive de la dent de scie et les fronts descendants coïncident avec chaque fin de rampe négative.

Le détecteur de transitions 1 (figure 1) est réalisé au moyen d'un circuit monostable qui délivre à une sortie S, dite troisième sortie, un créneau de tension négative à chaque transition positive ou négative du signal de données qu'il reçoit. La largeur de ces créneaux est proportionnelle, (voir ci-dessous) au produit $R_{13}C_{14}$, $R_{13}$ étant la valeur d'une résistance 13 reliée à la borne de réception du signal de données RD (point A) et $C_{14}$ la capacité d'un condensateur 14 disposé en série avec la résistance 13 entre le point A et la masse.

Le point commun aux éléments 13 et 14 (point E) est relié à l'entrée non inverseuse d'un comparateur 15 dont la sortie est rebouclée, par l'intermédiaire d'un inverseur 16 (dont la sortie est référencée H) et d'une résistance 17 de valeur $R_{17}$, sur son entrée inverseuse (point F). Le montage potentiométrique de deux résistances 18 et 19 de valeur $R_{18}$ et $R_{19}$ alimenté entre les tensions U et 0 permet d'obtenir en F une tension de seuil alternativement égale à $V_S$ ou à $U - V_S$, selon que le point H est à la tension 0 ou U, telle que:

$$U - V_S = \frac{U}{2} + \frac{Req \, U}{2(Req + R_{17})}, \text{ ce qui entraîne:}$$

$$V_s = \frac{U}{2} - \frac{\text{Req } U}{2(\text{Req} + R_{17})} \text{ avec Req} = \frac{R_{18} R_{19}}{R_{18} + R_{19}} \text{ et}$$
$$R_{18} = R_{19}$$

En pratique, on choisit Req = $R_{17}$ (valeurs liées aux performances des amplificateurs opérationnels utilisés), ce qui entraîne:

$$U - V_s = \frac{3U}{4} \quad \text{et} \quad V_s = \frac{U}{4}$$

L'entrée de données (point A) et le point H sont reliés aux entrées d'un circuit-porte OU exclusif 21 dont la sortie est reliée au point S. Le point S constitue, à l'intérieur du détecteur 1, l'entrée d'un injecteur de courant 22 comportant un inverseur 23 dont la sortie (point $B_1$) commande un interrupteur 24 ayant sa sortie (point $B_2$ dit première sortie du détecteur 1) reliée par l'intermédiaire d'une résistance 25 dite deuxième résistance, de valeur $R_{25}$, à l'entrée inverseuse de l'amplificateur opérationnel 5. Sur la figure 1, les éléments 5, 11, 12, 15, 16, 21, 23 et 24 sont alimentés entre la tension U et la masse.

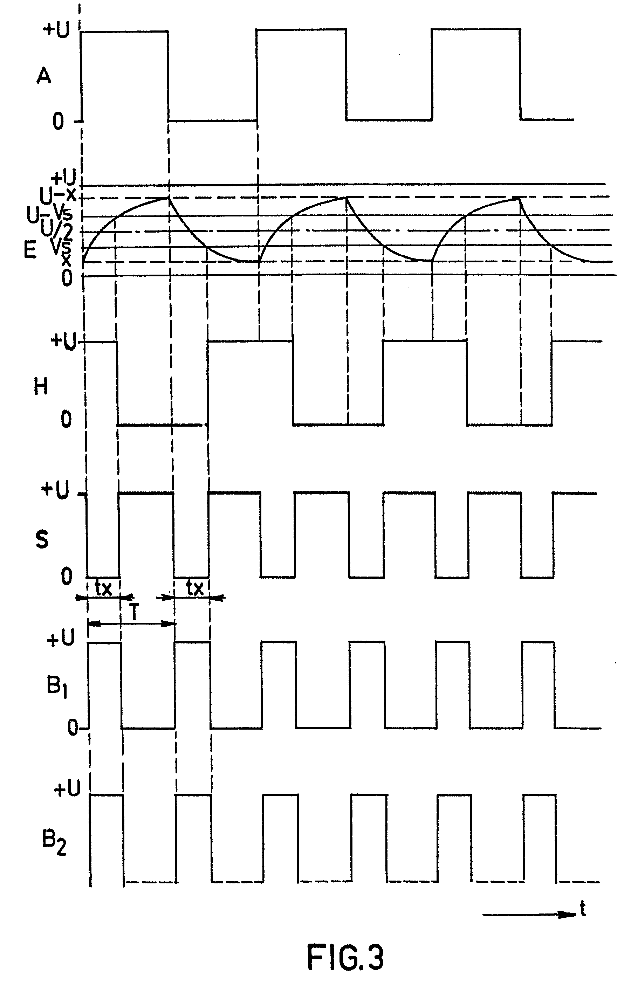

Le diagramme de temps de la figure 3 permet d'expliciter le fonctionnement du détecteur de transitions constitué par l'élément 1 qui contient l'élément 22, dans le cas particulier d'une suite régulièrement alternée des bits de données «1» et «0». Sur cette figure, on a représenté la forme des signaux de tension aux points A, E, H, S, $B_1$ et $B_2$.

– Calcul de la période $t_x$ du monostable en fonction de T, $R_{13}$, $C_{14}$, U et $V_s$:

La forme de tension $V_{EM}$ aux bornes du condensateur 14 pendant sa charge est:

$$V_{EM} = (U-x)(1-e^{-t/R_{13}C_{14}}) + x$$

soit, au temps $t_x$:

$$U - V_s = (U-x)(1-e^{-t_x/R_{13}C_{14}}) + x \quad (1)$$

et au temps T:

$$U - x = (U-x)(1-e^{-T/R_{13}C_{14}}) + x \quad (2)$$

On déduit de l'égalité (1):

$$V_s = (U-x)e^{-t_x/R_{13}C_{14}}, \text{ soit } e^{-t_x/R_{13}C_{14}} = \frac{V_s}{U-x} \quad (3)$$

et de l'égalité (2):

$$x = (U-x)e^{-T/R_{13}C_{14}}, \text{ soit } x = \frac{U \, e^{-T/R_{13}C_{14}}}{1 + e^{-T/R_{13}C_{14}}} \quad (4)$$

On déduit, des égalités (3) et (4):

$$t_x = R_{13}C_{14} \text{ Log} \frac{U-x}{V_s}$$

$$t_x = R_{13}C_{14} \text{ Log} \frac{U}{V_s} \left(1 - \frac{e^{-T/R_{13}C_{14}}}{1 + e^{-T/R_{13}C_{14}}}\right)$$

ou encore:

$$t_x = R_{13}C_{14} \text{ Log} \left(\frac{U}{V_s} \times \frac{1}{1 + e^{-T/R_{13}C_{14}}}\right)$$

Pour $V_s = \frac{U}{4}$ (voir ci-dessus):

$$t_x = R_{13}C_{14} \text{ Log} \frac{4}{1 + e^{-T/R_{13}C_{14}}} \quad (5)$$

La formule (5) est vraie pour une succession de bits «1» et «0» régulièrement alternés. En pratique, le temps séparant deux transitions successives du signal de données RD est un multiple k de T et la formule générale à considérer est:

$$t_x = R_{13}C_{14} \text{ Log} \frac{4}{1 + e^{-kT/R_{13}C_{14}}} \text{ (k entier positif)}$$

Or on verra ci-dessous que $t_x$ ne doit pas dépendre de la suite de bits «1» ou «0» reçue en RD. Il faut donc que le terme

$$e^{-T/R_{13}C_{14}},$$

et à fortiori le terme

$$e^{-kT/R_{13}C_{14}},$$

soit négligeable devant l'unité, soit: $e^{-T/R_{13}C_{14}} \ll 1$. La valeur de $t_x$ est du même ordre que celle du pas de correction $\theta$ de la synchrobit comme on le verra ci-dessous, ces deux valeurs étant choisies faibles par rapport à T et par exemple de l'ordre de $\frac{1}{16}$.

On peut montrer, à partir de l'équation:

$$\frac{t_x}{R_{13}C_{14}} = \text{Log} \frac{4}{1 + e^{-16t_x/R_{13}C_{14}}} \quad (6)$$

que le terme en $e^{-16t_x/R_{13}C_{14}}$ est négligeable devant l'unité, quel que soit T (T n'apparaissant pas dans l'équation (6)). Les équations obtenues à partir de $t_x = T/8$ et même de $t_x = T/4$ montrent que le terme en $e^{-T/R_{13}C_{14}}$ reste encore négligeable pour ces deux dernières valeurs de $t_x$.

En choisissant

$$t_x = \frac{T}{16},$$

la formule (5) se simplifie donc:

$$t_x = R_{13}C_{14} \text{ Log } 4 = 1{,}38 \, R_{13}C_{14}$$

ce qui correspond, pour un débit binaire de 1200 bauds par exemple, à:

$$t_x = \frac{1}{1200 \times 16} = 5{,}2 \; 10^{-5} \text{ s}$$

On en déduit:

$$R_{13}C_{14} = \frac{t_x}{1{,}38} = 3{,}77 \; 10^{-5} \text{ s}.$$

L'invention réside pour l'essentiel dans la façon dont le détecteur de transitions (1, 22) agit sur l'oscillateur 3 lors de chaque période $T_{OS}$ en modifiant sa phase par rapport au signal RD par injection de courant, à travers la résistance 25 dans le condensateur 6 pendant le temps $t_x$ qui s'écoule à partir de chaque transition de la donnée. A ce sujet, on notera que le correcteur de phase 2 est représenté sur la figure 1 comme l'ensemble des deux résistances 9 et 25 dont une borne commune est reliée à une borne du condensateur 6 et à l'entrée inverseuse (à la tension U/2) de l'amplificateur opérationnel 5.

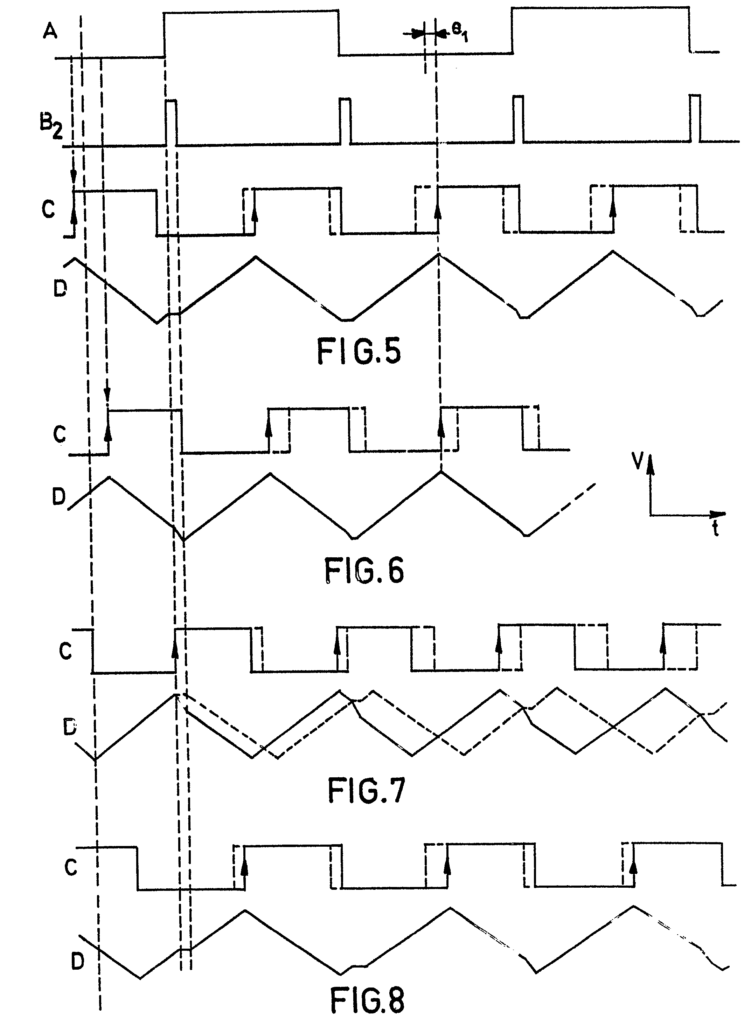

La figure 4 est un diagramme de temps des signaux de tension aux points A, $B_2$, C et D permettant d'expliciter le fonctionnement du circuit de synchrobit, dans le cas où la période $T_{OS}$ est suffisamment grande devant la période T pour que les décalages $\theta_1$ et $\theta_2$ sur le signal en D puissent se produire pendant la même période $T_{OS}$,

$$\frac{2\Pi}{T_{OS}}\,\theta_1$$

étant le déphasage (retard) apporté par la correction de phase lorsque la transition de la donnée (signal A) survient pendant la phase 1 (rampe positive en D), et

$$\frac{2\Pi}{T_{OS}}\,\theta_2$$

étant le déphasage (avance) apporté par la correction de phase lorsque la transition de la donnée survient pendant la phase 2 (rampe négative).

On notera par ailleurs que:

$$\theta_1 \cong \theta_2 \cong t_x.$$

D'autre part, on remarque que lorsque la transition de la donnée a lieu pendant la phase 1 (durée $\tau$), le courant de charge $i_1$ du condensateur 6 est égal à la différence des courants circulant dans les première et deuxième résistances, 9 et 25 respectivement.

Au contraire, si la transition a lieu pendant la phase 2 (durée $\tau'$), le courant $i'_1$ est égal à la somme des courants circulant dans les résistances 9 et 25.

Les valeurs des pentes des différents segments, en D, étant proportionnelles aux courants de charge ou de décharge du condensateur 6, si on choisit de prendre $R_{25} = R_9$ comme c'est généralement le cas en pratique, on obtient, comme le montre le calcul ci-dessous: $\theta_1 = t_x = \theta_2 = \theta$, $\theta$ étant le pas de correction (avance ou retard). En effet, le condensateur 6 étant chargé à courant constant, on a:

$$\text{Phase 1: } C_6\,\Delta V = i_1 t_x + i_2(\tau - t_x) \qquad (8)$$

$$\text{Phase 2: } C_2\,\Delta V = i'_1 t_x + i'_2(\tau' - t_x) \qquad (9)$$

D'autre part (en utilisant les admittances $Y_i$):

$$\Delta V = U\,\frac{Y_8}{Y_7}$$

$$i_1 = \frac{U}{2}\,Y_9 - \frac{U}{2}\,Y_{25} \quad \text{et} \quad i_2 = \frac{U}{2}\,Y_9$$

$$i'_1 = \frac{U}{2}\,Y_9 + \frac{U}{2}\,Y_{25} \quad \text{et} \quad i'_2 = \frac{U}{2}\,Y_9$$

L'égalité (8) entraîne:

$$C_6 U\,\frac{Y_8}{Y_7} = i_1\,t_x + i_2\tau - i_2\,t_x = i_2\tau + t_x(i_1 - i_2)$$

$$C_6 U\,\frac{Y_8}{Y_7} = \frac{U}{2}\,(Y_9\tau - Y_{25}\,t_x),\ \text{soit: } Y_9\tau = 2C_6\,\frac{Y_8}{Y_7} + Y_{25}\,t_x$$

soit encore: $\tau = \dfrac{2C_6\,\dfrac{Y_8}{Y_7} + Y_{25}\,t_x}{Y_9}$

L'égalité (9) entraîne, par un calcul analogue:

$$\tau' = \frac{2C_6\,\dfrac{Y_8}{Y_7} - Y_{25}\,t_x}{Y_9}$$

En pratique, on prend: $\dfrac{Y_8}{Y_7} = \dfrac{1}{2}\ (\Delta V = \dfrac{U}{2})$ et on obtient:

$$\tau = \frac{C_6 + Y_{25}\,t_x}{Y_9} \qquad (10)$$

$$\tau' = \frac{C_6 - Y_{25}\,t_x}{Y_9} \qquad (11)$$

Les égalités (10) et (11) montrent que deux corrections successives de signe contraire s'annulent. Ceci est le cas de la figure 4 pour lequel on a:

$$T_{OS} = \tau + \tau' = \frac{2C_6}{Y_9} = \frac{1}{F_{OS}}$$

formule identique à la formule (0) ci-dessus en l'absence de correction de phase.

Pour qu'il y ait modification de la fréquence $F_{OS}$ (de la période $T_{OS}$) et donc correction dans un sens (retard) ou dans l'autre (avance), il faut que le décalage du type $\theta_1$ ou $\theta_2$ n'apparaisse qu'une fois au cours de chaque période $T_{OS}$ et soit toujours du même type jusqu'à obtention de la synchronisation. On peut montrer que ceci se produit lorsque et seulement lorsque les fréquences F et $F_{OS}$ ou les périodes correspondantes sont suffisamment proches l'une de l'autre et plus précisément lorsque:

$$|\,T - T_{OS}\,| < \text{Inf}(\theta_1, \theta_2) \qquad (12)$$

$\text{Inf}(\theta_1, \theta_2)$ étant la plus petite des deux valeurs $\theta_1$ et $\theta_2$.

Dans la suite du texte, on considère que $R_{25} = R_9$, ce qui entraîne: $t_x = \theta_1 = \theta_2 = \theta$, et la condition (12) devient:

$$|\,T - T_{OS}\,| < \theta \qquad (13)$$

Dans les conditions, si la première transition intervient lors d'une rampe positive (phase 1), la période de l'oscillateur est (voir le chronogramme de la figure 5):

$$T'_{OS} = \frac{2C_6 + Y_{25}\,t_x}{Y_9} \qquad (14)$$

soit dans le cas particulier préféré où $Y_{25} = Y_9$:

$$T'_{OS} = \frac{2C_6}{Y_9} + \theta = T_{OS} + \theta \quad \text{et la condition (13)}$$

devient: $\qquad 0 < T'_{OS} - T < 2\theta$

Cette double inégalité signifie donc qu'en cas d'avance du signal d'oscillateur sur le signal de données, un rattrapage de phase compris entre 0 et $2\theta$ est apporté à chaque période d'oscillateur (diminution de $F_{OS}$) jusqu'à obtention de la synchronisation qui est réalisée lorsque chaque front descendant du signal en C coïncide sensiblement avec chaque transition du signal en A.

De façon symétrique, si la première transition intervient lors d'une rampe négative (phase 2), la période de l'oscillateur est (voir le chronogramme de la figure 6):

$$T''_{OS} = \frac{2C_6 - Y_{25}\,t_x}{Y_9} \qquad (15)$$

soit, dans le cas particulier où $Y_{25} = Y_9$:

$$T''_{OS} = \frac{2C_6}{Y_9} - \theta = T_{OS} - \theta$$

et la condition (13) devient:

$$-2\theta < T''_{OS} - T < 0$$

Cette double inégalité signifie qu'en cas de retard du signal d'oscillateur sur le signal de données, un rattrapage de phase compris entre 0 et $2\theta$ est apporté à chaque période d'oscillateur (augmentation de $F_{OS}$) jusqu'à obtention de la synchronisation qui est réalisée, comme dans le cas précédent lorsque chaque front descendant du signal en C coïncide sensiblement avec chaque transition du signal en A.

On notera, dans les formules générales (14) et (15) que pour $Y_{25} = 0$ ($R_{25} = \infty$), on obtient: $T'_{OS} = T''_{OS} = T_{OS}$.

La synchronisation est obtenue dès qu'un front descendant du signal en C intervient pendant une impulsion du signal en $B_2$. On obtient alors pendant la durée $t_x$ (soit $\theta$) de cette impulsion une double correction, d'abord du type $\theta_2$ (phase 2) et de durée $at_x$ ($a\theta$ avec: $0 < a < 1$) jusqu'à ce que la sortie de l'oscillateur (point C) bascule de U à O, puis du type $\theta_1$ (phase 1) et durée $(1-a)t_x$ soit ($[1-a]\theta$). Dans le cas particulier où $T = T_{OS}$, on obtient: $a = 1 - a = 0,5$. Lorsque les deux périodes diffèrent légèrement, dans les limites de la condition (13), les durées: $a\theta$ et $(1-a)\theta$ sont dans des rapports tels que la période de l'oscillateur se maintient rigoureusement égale à la période T des données, le maintien du synchronisme impliquant l'égalité des fréquences. Ce fonctionnement est visible sur les chronogrammes des figures 5 et 6, pour le cas particulier où: $a = 1 - a = 0,5$.

On notera par ailleurs qu'au synchronisme, la rampe positive en D commence au temps $t_x$ (soit $\theta$) après la transition de la donnée. Ceci implique, lorsque les pentes des rampes positive et négative en D sont égales en valeur absolue, que l'instant d'écantillonnage (front montant en C) est chaque fois en retard de la durée $\theta_1$ (soit $\theta$) par rapport à l'instant optimal d'échantillonnage (T/2 après une transition), ceci dans le cas où: $T = T_{OS}$. Si les périodes T et $T_{OS}$ satisfont à la condition (13), ce retard à l'échantillonnage est donc compris entre $\theta_1/2$ et $3\theta_1/2$ (soit $\theta/2$ et $3\theta/2$). On rappelle qu'en pratique, on choisit:

$$\theta = \frac{T}{16}.$$

La transition en milieu de bit du signal d'horloge (front montant au point C) est donc systématiquement décalée d'un pas en retard sur la transition théorique en milieu de bit et n'est pas affectée de gigue (vacillement de $\pm 1$ pas) comme sur une synchrobit numérique.

Comme illustré sur le chronogramme de la figure 7 où l'on part d'une opposition de phases entre les données reçues (point A) et la fréquence d'horloge (point C), on remarque, dans le cas où: $T = T_{OS}$, que la synchronisation, par effet avance (trait plein en C et D) ou par effet retard (trait interrompu en D), a lieu à la huitième transition du signal de données (point A). Ceci correspond à un «rattrapage» de phase de T/2 à raison d'un rattrapage de $\theta = T/16$ à chaque transition du signal de données. Le trait interrompu en C indique ce que serait le signal d'oscillateur en l'absence de correction (avance ou retard).

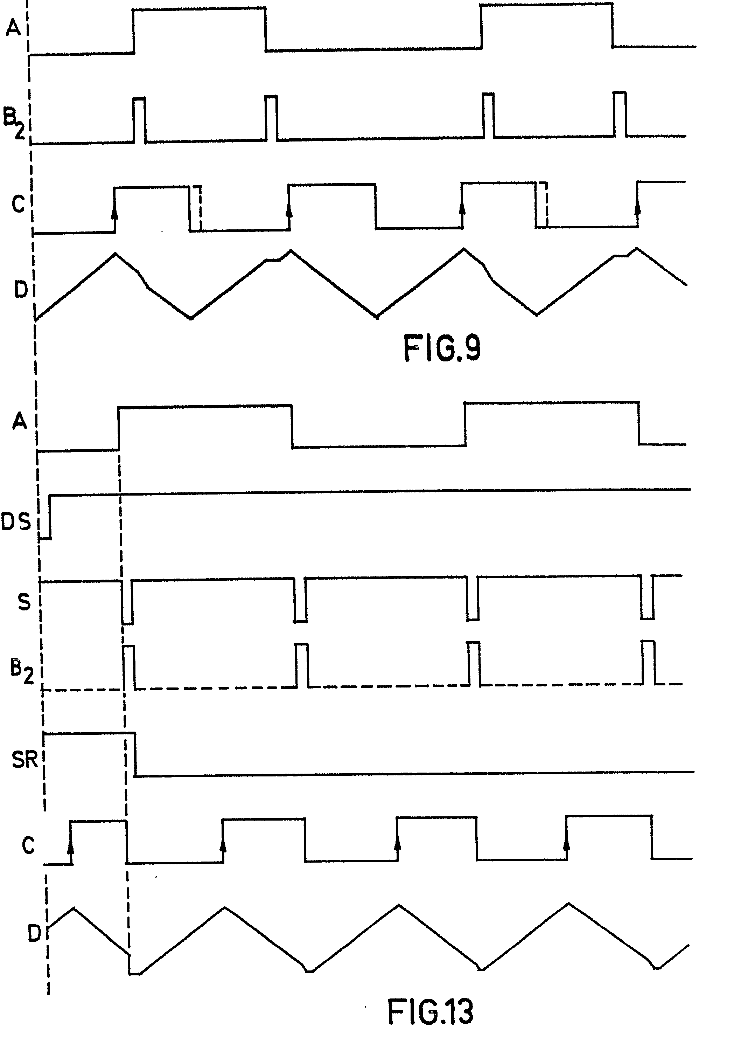

Le chronogramme de la figure 8 montre le cas où: $|T - T_{OS}| > \theta$ (en l'occurrence: $T_{OS} - T > \theta$).

On peut constater sur cette figure que l'on passe, pour la correction de $T_{OS}$, de la correction du type $\theta_1$ (retard) à la correction du type $\theta_2$ (avance) sans obtenir la synchronisation.

De même, comme le montre la figure 9, du fait d'une distorsion biaise supérieure au pas de correction $\theta$ sur le signal de données reçu, la synchronisation est impossible par le circuit de synchrobit selon l'invention, même si la condition (13) est remplie et il faut utiliser dans ce cas un circuit de synchronisation rapide qui présente le désavantage d'une inertie nulle et d'une sensibilité totale aux impulsions parasites dans le signal de données.

On a vu ci-dessus que $T/2\theta$ transitions sont nécessaires pour obtenir à coup sûr la synchronisation, soit 8 transitions pour: $\theta = T/16$. Il suffit donc d'envoyer un préfixe de 8 bits alternés (quatre «0» et quatre «1») en début de message pour assurer une synchronisation correcte. Dans ce cas, la distorsion biaise maximale admissible à la réception est inférieure à 1/16, soit inférieure à 6%.

Il est parfois utile d'obtenir la synchronisation dès le début du message. Il est alors nécessaire d'ajouter au dispositif déjà décrit (figure 1) un dispositif de synchronisation rapide (figure 10 – Planche 1). Dans ce cas, on dispose d'un signal de détection de données DS dont la montée provoque, comme décrit ci-dessous, le passage de la synchronisation rapide à la synchronisation lente obtenue à partir du circuit de la figure 1.

Le circuit de la figure 10 comporte ou non une bascule D 26 selon que la montée du signal DS est antérieure ou postérieure à la première transition du signal RD (début du message). Cette particularité est indiquée symboliquement par la présence du commutateur à deux positions 27. On décrit d'abord la partie de la figure 10 située à droite du trait interrompu médian, en supposant que cette partie n'est pas reliée à la partie gauche de la figure. Cette partie droite comprend trois résistances 28, 29 et 31 dites respectivement troisième, quatrième et cinquième résistances, de valeurs respectives $R_{28}$, $R_{29}$, $R_{31}$, disposées en cascade entre la masse et la tension + U. Le point commun aux résistances 28 et 29 (point P) est relié à une borne D' par l'intermédiaire d'un interrupteur 32 et le point commun aux résistances 29 et 31 (point Q) à une borne G' par l'intermédiaire d'un interrupteur 33. Les interrupteurs 32 et 33 sont commandés en parallèle à partir de la deuxième borne d'entrée $B'_1$ via une résistance 34 de valeur $R_{34}$ de façon à être ouverts pour une tension de commande nulle et fermés pour une tension de commande égale à + U. Les valeurs des résistances 28, 29 et 31 sont choisies telles que les potentiels en P et Q soient respectivement égaux à:

$$\frac{U}{2}\left(1-\frac{R_7}{R_8}\right) \text{ et } \frac{U}{2}.$$

Pour relier le circuit de la figure 10 au circuit de la figure 1 on branche entre elles respectivement les bornes $B_1$ et $B'_1$, G et G', D et D'. Il s'ensuit que dès la première transition du signal RD, le potentiel du point C bascule immédiatement de U à 0, le condensateur 6 se déchargeant très vite à travers la résistance 29, pendant un temps nettement inférieur à $t_x$ et la rampe de tension du signal en D commence, à sa valeur de tension correcte:

$$\frac{U}{2}\left(1-\frac{R_7}{R_8}\right)$$

dès la fin de la durée $t_x$. Ce fonctionnement est indiqué à la partie gauche des chronogrammes des figures 11, 12 et 13.

La partie gauche de la figure 10 représente un circuit qui permet d'exploiter la mise à disposition du signal de détection de données DS.

Si la montée du signal DS est postérieure à la première transition du signal RD (voir figures 11 et 12), le commutateur 27 est dans la position indiquée sur la figure (bascule D inhibée ou absente) et le signal DS est transmis à la commande des interrupteurs 32 et 33 par l'intermédiaire d'un inverseur 35 et d'une diode 36 montée en inverse. Le fonctionnement qui résulte de ce montage est indiqué aux figures 11 et 12; la montée du signal DS provoque l'ouverture permanente des interrupteurs 32 et 33 (inhibition du circuit de la figure 10). Les chronogrammes sont tracés pour deux conditions initiales différentes: en bas, figure 12, le signal d'horloge est en retard par rapport à la transition théorique en milieu de bit (de moment élémentaire); au-dessus, figure 11, le signal d'horloge est en avance.

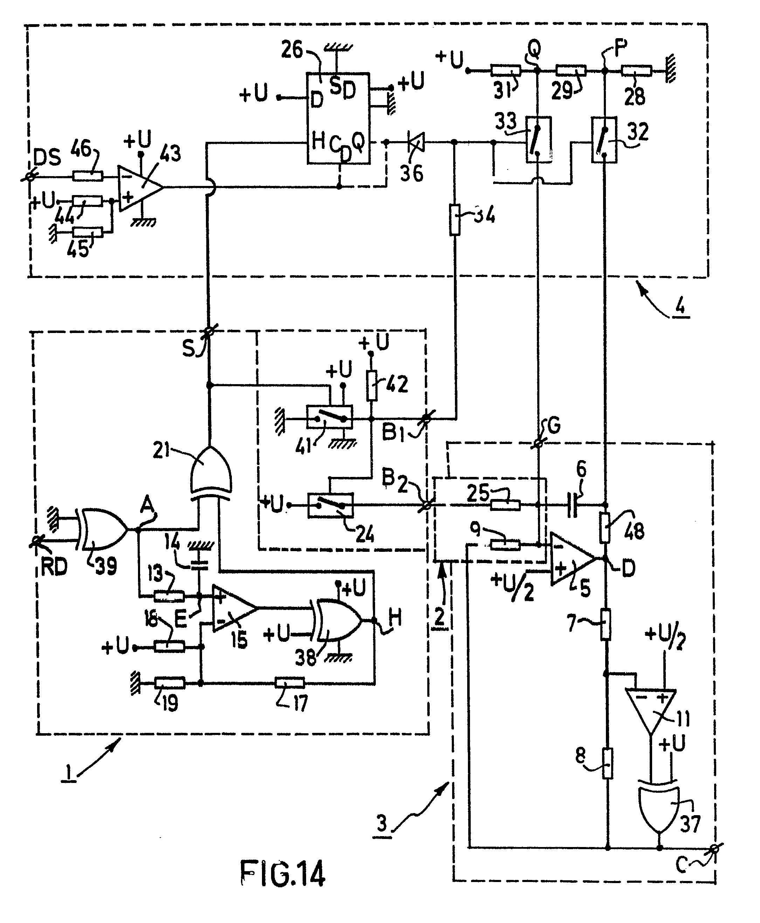

Si la montée du signal DS précède la première transition du signal RD (voir figure 13), le circuit de la figure 10 comporte la bascule D référencée 26 et le commutateur 27 (actionné de préférence manuellement) a la position inverse de celle indiquée sur la figure. Dans ce cas, le signal DS est fourni après inversion en 35 à l'entrée Cd de remise à zéro de la bascule et le signal en S (figure 1) est fourni, via une borne S', dite troisième borne d'entrée du circuit de synchronisation rapide, à l'entrée d'horloge de la bascule D. La cathode de la diode 36 étant reliée à la sortie $\overline{Q}$ de la bascule (signal SR), le fonctionnement est celui indiqué à la figure 13: la montée du signal DS provoque la retombée du signal SR au temps $t_x$ après la première transition, ce qui permet la synchronisation rapide lors de la première transition puis l'ouverture permanente des interrupteurs 32 et 33 (circuit de la figure 10 inhibé), à partir de la deuxième transition (maintien de synchronisation par le circuit de synchrobit de la figure 1). A la figure 10, les éléments 26, 32, 33 et 35 sont alimentés entre la tension U et la masse.

Dans les circuits des figures 1 et 10 on s'est attaché à décrire avant tout les fonctions logiques ou analogiques. Dans la pratique le circuit est, de préférence, réalisé comme décrit en référence à la figure 14. Etant donné que le circuit est un circuit analogique, une assez grande précision est requise, sur les valeurs de tension notamment, et certains éléments doivent être rajoutés ou modifiés par rapport aux schémas des figures 1 et 10. Le circuit de la figure 14 présente les avantages suivants:

– Circuit simple de réalisation et d'utilisation:
  – l'oscillateur retenu ne nécessite pas de générateur d'horloge à quartz;
  – une seule tension d'alimentation est nécessaire (tension U);
  – les entrées/sorties sont compatibles CMOS;

– Circuit compact et économique:
  – l'ensemble des fonctions peut être regroupé sur un circuit hybride (couches épaisses) de 50 mm × 25,4 mm (2″ × 1″);
  – il ne comporte que trois boîtiers de circuits intégrés (un amplificateur opérationnel quadruple réalisé en technique BIFET, un interrupteur quadruple et un circuit-porte OU exclusif quadruple réalisé en technologie CMOS);

– Circuit performant:
  – le dispositif présente une bonne stabilité vis-à-vis des variations de température et de la tension d'alimentation;
  – la fiabilité est accrue par l'emploi de la technologie des circuits hybrides à couches épaisses;
  – le signal de base de temps fourni (point C) n'est pas affecté de gigue («jitter» en langue anglaise) comme sur les circuits de synchrobit numériques.

Sur la figure 14, les inverseurs 12 et 16 de la figure 1 sont réalisés au moyen de circuits-portes OU exclusif, 37 et 38, respectivement, dont une entrée est à la tension + U. Dans le détecteur de transitions 1, un circuit-porte OU exclusif 39 a pour fonction de délivrer au point A une tension bien calibrée. Eventuellement, afin de rendre compatibles les technologies CMOS du circuit 39 avec la technologie BIFET de l'élément 15, un montage potentiométrique (non représenté) permet d'imposer au point A les deux valeurs de tension $\varepsilon U$ et $(1-\varepsilon)U$, $\varepsilon$ étant un nombre petit par rapport à 1. Ceci permet d'éviter un phénomène de verrouillage («latching» en langue anglaise) de l'élément 15. L'inverseur 23 est réalisé par un interrupteur 41 commandé à partir du point S, dont une borne est reliée à la masse et l'autre borne (point $B_1$) est reliée à la tension d'alimentation $+ U$ par l'intermédiaire d'une résistance 42 de valeur $R_{42}$. L'inverseur 35 (figure 10) est réalisé au moyen d'un amplificateur opérationnel monté en comparateur 43 (il pourrait aussi être réalisé par un circuit-porte OU exclusif monté comme les éléments 37 ou 38). Les conducteurs en trait interrompu figurés entre les éléments 36 et 43 indiquent les deux possibilités d'exploitation du signal DS déjà décrites ci-dessus, qui correspondent à deux modes de réalisation du circuit de synchronisation rapide. Les quatres circuits-portes OU exclusif 21, 37, 38, 39 appartiennent à une puce de circuit intégré («chip»), de même que les quatre amplificateurs opérationnels 5, 11, 15, 43 et que les quatre interrupteurs 24, 32, 33, 41, chacune des trois puces étant alimentée entre la tension $+ U$ et la masse. On notera qu'une résistance 48 de valeur $R_{48}$ est interposée entre le condensateur 6 et le point D. Cette résistance, de faible valeur, a pour fonction de protéger l'amplificateur opérationnel 5 lorsque les interrupteurs 32 et 33 sont fermés et sa présence ne change rien au fonctionnement du dispositif de synchrobit décrit ci-dessus. Les résistances sont réalisées selon la technologie hybride et peuvent être ajustées mécaniquement, dans le sens d'une augmentation de leur valeur, par érosion au moyen d'un laser.

Les valeurs de certains composants du circuit de la figure 14 sont par exemple les suivantes:

| | | | |
|---|---|---|---|
| $C_6$ | $= 2,7$ nF | $R_{18}$ | $= R_{19} = 20$ k$\Omega$ |
| $R_7$ | $= 10$ k$\Omega$ | $R_{17}$ | $= 10$ k$\Omega$ |
| $R_8$ | $= 20$ k$\Omega$ | $R_{42}$ | $= 10$ k$\Omega$ |
| $R_{48}$ | $= 1$ k$\Omega$ | $R_{28}$ | $= R_{29} = 1,1$ k$\Omega$ |
| $R_9$ | $= R_{25} = 154$ k$\Omega$ | $R_{31}$ | $= 2$ k$\Omega$ |
| $R_{13}$ | $= 37,4$ k$\Omega$ | $R_{44}$ | $= 10$ k$\Omega$ |
| $C_{14}$ | $= 1$ nF | $R_{45}$ | $= 2,7$ k$\Omega$ |
| | | $R_{46}$ | $= 100$ k$\Omega$ |

Selon un mode de réalisation particulier, non représenté, l'absence de gigue de l'instant d'échantillonnage peut être mise à profit pour améliorer la précision de l'instant d'échantillonnage. On a vu en effet ci-dessus que lorsque les rampes de tension (point D) ont la même pente, en valeur absolue, le retard à l'échantillonnage est, en moyenne, égal au pas de correction $\theta$. Il est possible, à peu de frais, d'annuler le temps de retard moyen: pour cela, il suffit d'augmenter légèrement la pente de la rampe positive et de diminuer légèrement la pente de la rampe négative de façon que la période libre $T_{os}$ de l'oscillateur reste inchangée. Dans ces conditions, chaque front montant du signal de base de temps apparaît alors sensiblement en milieu de moment élémentaire.

Si l'on pose: $\theta = k'T$ ($\theta \simeq k'T_{os}$), $k'$ étant un nombre petit devant l'unité, les pentes des rampes positive et négative doivent donc être modifiées de façon que l'on ait:

$$\Delta T_1 = \frac{T_{os}}{2} (1-2k') \quad \text{et} \quad \Delta T_2 = \frac{T_{os}}{2} (1 + 2k')$$

Soit, par exemple pour $k' = 1/16 = 0,0625$:

$$\Delta T_1 = 0,875 \frac{T_{os}}{2} \tag{16}$$

$$\Delta T_2 = 1,125 \frac{T_{os}}{2} \tag{17}$$

Ce résultat peut être obtenu en première approximation par exemple en augmentant légèrement la valeur de la tension sur l'entrée non inverseuse de l'amplificateur opérationnel 5. Soit $k'' \frac{U}{2}$ cette nouvelle valeur de tension, $k''$ étant un nombre légèrement supérieur à 1. Les calculs montrent que pour:

$$\frac{1 + 4 k'}{1 + 2 k'} < k'' < \frac{1}{1 - 2 k'} \tag{18}$$

on obtient sensiblement les valeurs recherchées pour $\Delta T_1$ et $\Delta T_2$. En poursuivant l'application numérique: $k' = 1/16$, on obtient par exemple pour $k'' = 1,12$ (satisfaisant à l'inégalité (18) ci-dessus):

$$T''_{os} = 1,014 \, T_{os} \quad \text{avec} \quad \Delta T_1 = \frac{1}{k''} \frac{T_{os}}{2} = 0,893 \frac{T_{os}}{2}$$

$$\text{et} \, \Delta T_2 = \frac{1}{2 - k''} \frac{T_{os}}{2} = 1,136 \frac{T_{os}}{2}$$

Les pentes des rampes qui étaient proportionnelles aux courants $i_1$, $i_2$, $i'_1$, $i'_2$, soit à $0$, $1$, $-2$, $-1$ respectivement deviennent alors proportionnelles à $k''-1$, $k''/2$, $k''-2$

$$\text{et} \, \frac{k''}{2} - 1,$$

soit à: $0,24$; $1,12$; $-1,76$; $-0,88$ et:

$$t_x = \theta_2 = T/16 \quad \text{et} \quad \theta_1 = 0,75 \, T/16$$

On peut aussi vérifier, dans cette application numérique, que le retard moyen à l'échantillonnage est sensiblement dix fois plus faible ($\theta/10$ au lieu de $\theta$). La petite augmentation de 1,4% apportée à la période $T_{os}$ de l'oscillateur est facilement compensée dès que la synchronisation est obtenue.

Si l'on veut conserver à l'oscillateur sa période $T_{os}$, il est possible d'agir en outre sur le rapport

$$\frac{R_7}{R_8},$$

auquel $\Delta V$ et par suite $T_{os}$ et $\theta_1$ sont proportionnels, en multipliant ce rapport par une valeur m proche de l'unité.

Dans l'exemple numérique choisi ci-dessus, il faut donc prendre:

$$m = \frac{1}{1,014} = 0,986,$$

ce qui entraîne:

$$T'''_{os} = T_{os} \quad \text{avec} \quad \Delta T_1 = 0,88 \frac{T_{os}}{2}$$

$$\text{et} \quad \Delta T_2 = 1,12 \frac{T_{os}}{2},$$

les valeurs de $\Delta T_1$ et $\Delta T_2$ étant très proches des valeurs théoriques des formules (16) et (17) et:

$$\theta_1 = 0,75 \times 0,986 \frac{T}{16} = 0,74 \frac{T}{16}.$$

Il faut noter, en vertu de la condition (12) ci-dessus, que l'on doit avoir, pour que la synchronisation soit obtenue dans tous les cas:

$$|T - T_{os}| < \theta_1, \text{ soit: } |T - T_{os}| < 0,046 \, T.$$

## Revendications

1. Dispositif de synchronisation bit recevant, en mode de transmission asynchrone, des données sous forme de trains d'impulsions binaires qui présentent des transitions détectables entre des états binaires, chaque bit ayant la durée T, comportant un oscillateur (3) qui engendre un signal de base de temps dont la fréquence libre est sensiblement égale au double du débit binaire desdits trains d'impulsions, comportant un détecteur de transitions (1, 22) qui délivre sur une première sortie (B₂) une impulsion de tension positive calibrée en amplitude et en durée lors de chaque transition du signal de données, dans lequel ledit oscillateur (3) fournit un signal de tension interne triangulaire à la fréquence dudit signal de base de temps et des moyens de correction de phase (2) étant prévus entre la première sortie (B₂) du détecteur de transitions et l'entrée dudit oscillateur (3) pour modifier la pente dudit signal de tension interne dans le sens d'une variation unidirectionnelle en valeur algébrique, pendant la durée de ladite impulsion calibrée, caractérisé en ce que ledit détecteur de transitions (1, 22), ledit oscillateur (3) et lesdits moyens de correction de phase (2) sont conçus et agencés entre eux de telle sorte que ladite variation unidirectionnelle soit une diminution de valeur prédéterminée apte à créer un pas de correction sous forme d'un retard prédéterminé constant (respectivement une avance prédéterminée constante) de phase lorsque ladite impulsion calibrée se produit lors d'une rampe positive (respectivement négative) dudit signal de tension interne triangulaire qui est formé de segments de droite et que la durée de chaque pas de correction, sensiblement égale à celle de ladite impulsion calibrée, soit faible devant la durée T d'un bit de façon que, avant l'obtention de la synchronisation, la correction n'agisse individuellement que sur la rampe positive (respectivement négative) dudit signal de tension interne triangulaire.

2. Dispositif de synchronisation bit dans lequel l'oscillateur (3) comporte un amplificateur opérationnel (5) monté avec un condensateur (6) relié à son entrée inverseuse pour former un circuit intégrateur dont la sortie est connectée à une bascule à seuil avec hystérésis (11, 12) fournissant un signal de base de temps sous forme d'une tension bivalente qui est appliquée à une borne d'une première résistance (9) dont l'autre borne est à relier à l'entrée inverseuse dudit amplificateur opérationnel, selon la revendication 1, caractérisé en ce que ledit signal de tension interne triangulaire est obtenu à la sortie dudit amplificateur opérationnel et que lesdits moyens de correction de phase sont constitués par une deuxième résistance (25) connectée entre ladite première sortie dudit détecteur de transitions et l'entrée inverseuse dudit amplificateur opérationnel et dont la valeur est du même ordre que celle de ladite première résistance.

3. Dispositif de synchronisation bit dans lequel les pentes dudit signal interne triangulaire sont égales en valeur absolue selon la revendication 2, caractérisé en ce que les valeurs desdites première et deuxième résistances (9 et 25) sont égales de façon que ledit pas de correction de phase soit le même dans le sens retard ou dans le sens avance de phase.

4. Dispositif de synchronisation bit pour lequel un signal de détection de données (DS) est disponible selon la revendication 2 ou 3, caractérisé en ce qu'il comporte en outre un circuit de synchronisation rapide (4) constitué par le montage potentiométrique d'une troisième (28), d'une quatrième (29) et d'une cinquième résistance (31) tel que les points communs entre la troisième et la quatrième résistance d'une part (P) et entre la quatrième et la cinquième résistance d'autre part (Q) sont, par des moyens de connexion comportant deux interrupteurs commandables (32 et 33) branchés entre lesdits points communs et lesdites bornes du condensateur, reliés aux bornes dudit condensateur au moins pendant la durée de la première desdites impulsions apparaissant, lors de chaque train de données pour chaque transition du signal de données, les valeurs desdites troisième, quatrième et cinquième résistances (28, 29, 31) étant telles qu'une remise en phase autoritaire totale desdits signaux triangulaire et de base de temps soit obtenue pendant la durée de ladite première impulsion.

5. Dispositif de synchronisation bit pour lequel la montée du signal de détection de données (DS) est postérieure à l'apparition de ladite première impulsion selon la revendication 4, caractérisé en ce que l'entrée de commande commune desdits interrupteurs (32, 33) est reliée d'une part à une deuxième sortie (B₁) dudit détecteur de transitions (1, 22), et reçoit d'autre part par l'intermédiaire d'un inverseur (35) et d'une diode (36) montée en inverse ledit signal de détection de données.

6. Dispositif de synchronisation bit pour lequel la montée du signal de détection de données (DS) précède l'apparition de ladite première impulsion selon la revendication 4, caractérisé en ce que l'entrée de commande commune desdits interrupteurs est reliée d'une part à une deuxième sortie (B₁) dudit détecteur de transitions (1, 22), d'autre part à la sortie Q d'une bascule D (26) par l'intermédiaire d'une diode (36), ladite bascule D recevant sur son entrée de remise à zéro le signal de détection de données par l'intermédiaire d'un inverseur (35) et sur son entrée d'horloge un troisième signal de sortie (S) dudit détecteur de transitions (1, 22).

7. Dispositif de synchronisation bit selon l'une quelconque des revendications précédentes, caractérisé en ce que ledit signal triangulaire a une pente de rampe positive accrue et une pente de rampe négative diminuée, en valeur absolue, de façon telle que lors de la synchronisation, chaque front montant dudit signal de base de temps apparaisse sensiblement en milieu de moment élémentaire.

8. Dispositif de synchronisation bit selon la revendication 7, caractérisé en ce que les modifications de pente des rampes positive et négative dudit signal triangulaire sont obtenues essentiellement par modification de la tension de polarisation de l'entrée non inverseuse dudit amplificateur opérationnel (5) monté en intégrateur de l'oscillateur (3).

9. Dispositif de synchronisation bit selon l'une quelconque des revendications précédentes, caractérisé en ce que les circuits utilisés sont réalisés en technologie CMOS ou compatible CMOS, et/ou en technologie des circuits hybrides couches épaisses.

**Claims**

1. A bit synchronization arrangement receiving, in an asynchronous transmission mode, data signals in the form of binary pulse trains having detectable transitions between binary states, each bit having a duration T, the arrangement comprising an oscillator (3) producing a time base signal whose free frequency is substantially equal to twice the binary rate of said pulse trains, and a transition detector (1, 22) supplying at a first output (B₂) a positive voltage pulse calibrated in amplitude and in duration at each transition of said data signals, in which said oscillator (3) supplies a triangular internal voltage signal at the frequency of said time base signal, and phase correction means (2) provided between a first output (B₂) of said transition detector and the input of said oscillator (3) for modifying the slope of said internal voltage signal in the sense of a variation that is unidirectional as to its algebraic value and that occurs in the time of the duration of said calibrated pulse, characterized in that the said position detector (1, 22), said oscillator (3) and said phase correction means (2) are designed and mutually arranged such that said unidirectional variation is a predetermined value reduction suitable to produce a correction step in the form of a predetermined constant delay (or a constant predetermined advance, respectively) in phase when said calibrated pulse occurs during a positive (or negative, respectively) ramp of said internal triangular voltage signal, which is formed from straight line segments and that the duration of each correction step, which is substantially equal to the duration of said calibrated pulse, is short with respect to the duration T of a bit, such that, before synchronization has been obtained, the correction acts only individually on the positive (or negative, respectively) ramp of said internal triangular voltage signal.

2. A bit synchronization arrangement as Claimed in Claim 1, in which the oscillator (3) comprises an operational amplifier (5) having a capacitor (6) connected to its inverting input so as to form an integrating circuit, whose output is connected to a bistable circuit (11, 12) having threshold hysteresis and supplying a time base signal in the form of a two-level voltage which is applied to one end of a first resistor (9) whose other end is connected to the inverting input of said operational amplifier, characterized in that said triangular internal voltage signal is obtained at the output of said operational amplifier and in that said phase correction means are constituted by a second resistor (25) which is connected between said first output of said transition detector and the inverting input of said operational amplifier and whose value is of the same order as that of said first resistor.

3. A bit synchronization arrangement as Claimed in Claim 2, in which the slopes of said triangular internal signal are equal in absolute value, characterized in that the values of said first and second resistors (9 and 25) are equal so that said phase correction step in the phase delaying and the phase advancing senses is the same.

4. A bit synchronization arrangement as claimed in Claim 2 or 3, for which a data detection signal (DS) is available, characterized in that it further comprises a fast synchronization circuit (4) constituted by a potentiometer arrangement of a third (28), a fourth (29) and a fifth resistor (31) such that the junction points between the third and fourth resistors on the one hand (P) and between the fourth and fifth resistors on the other hand (Q) are connected, by connection means comprising two controllable interruptors (32 and 33) between said junction points and the ends of the capacitor, to said ends of said capacitor at least in the time of the duration of the first of said pulses occuring during each data train for each transition of the data signal, the values of said third, fourth and fifth resistors (28, 29, 31) being such that a complete imposed phase resetting of said triangular and time base signals is obtained during the duration of said first pulse.

5. A bit synchronization arrangement as claimed in Claim 4, in which the data detection signal (DS) ascends after the occurrence of said first pulse, characterized in that a common control input of said interruptors (32, 33) is connected to a second output (B₁) of said transition detector (1, 22), and also receives said data detection signal through an inverter (35) and a reverse-connected diode (36).

6. A bit synchronization signal arrangement as claimed in Claim 4, in which the data detection signal (DS) ascends before the occurrence of said first pulse, characterized in that a common control input of said interruptors is connected to a second output ($B_1$) of said transition detector (1, 22) and also to the $\overline{Q}$-output of a D flip-flop (26) through a diode (36), said D flip-flop receiving said data detection signal at its reset input through an inverter (35), and a third output signal (S) of said transition detector (1, 22) at its clock input.

7. A bit synchronization arrangement as claimed in any one of the preceding Claims, characterized in that said triangular signal has an increased positive ramp slope and a negative ramp slope that is decreased in absolute value, such that during synchronization each leading edge of said time base signal occurs approximately halfway an elementary data interval.

8. A bit synchronization arrangement as claimed in Claim 7, characterized in that the modifications of the slopes of the positive and negative ramps of said triangular signal are basically obtained by modifying the bias voltage at the noninverting input of said operational amplifier (5) connected so as to form an integrating circuit of said oscillator (3).

9. A bit synchronization arrangement as claimed in any one of the preceding Claims, characterized in that the circuits used are implemented in CMOS or CMOS-compatible technology and/or thick-film hybrid circuit technology.

**Patentansprüche**

1. Bitsynchronisieranordnung zum im asynchronen Übertragungsmodus Empfangen von Daten in Form binärer Impulsfolgen, die detektierbare Übergänge zwischen binären Zuständen wobei jedes Bit die Dauer T hat, mit einem Oszillator (3), der ein Zeitbasissignal erzeugt, dessen freie Frequenz der doppelten Bitfrequenz der genannten Impulsfolgen nahezu entspricht, mit einem Übergangsdetektor (1, 22), der an einem ersten Ausgang ($B_2$) bei jedem Datensignalübergang einen in der Amplitude und in der Dauer kalibrierten positiven Spannungsimpuls liefert, wobei der genannte Oszillator (3) ein inneres Dreieckspannungssignal liefert mit der Frequenz des genannten Zeitbasissignals und wobei zwischen dem ersten Ausgang ($B_2$) des Übergangsdetektors und dem Eingang des genannten Oszillators (3) Phasenkorrekturmittel (2) vorgesehen sind zum Ändern der Neigung des genannten inneren Spannungssignals im Sinne einer algebraischen Einrichtungsänderung während der Dauer des genannten abgestimmten Impulses, dadurch gekennzeichnet, dass der genannte Übergangsdetektor (1, 22), der genannte Oszillator (3) und die genannten Phasenkorrekturmittel (2) derart angeordnet sind, dass die genannte Einrichtungsänderung eine vorbestimmte Wertverringerung ist, die dazu geeignet ist, einen Korrekturschritt in Form einer vorbestimmten konstanten Phasenverzögerung (bzw. einer vorbestimmten konstanten Phasenvoreilung) zu erzeugen, wenn der genannte kalibrierte Impuls während einer positiven (bzw. negativen) Flanke des genannten inneren aus geraden Segmenten bestehenden Dreieckspannungssignals auftritt und dass die Dauer jedes Korrekturschrittes, die im wesentlichen der des genannten kalibrierten Impulses entspricht, gegenüber der Dauer T eines Bits derart gering ist, dass die Korrektur vor dem Erhalten der Synchronisierung nur einzeln auf die positive (bzw. negative) Flanke des genannten inneren Dreieckspannungssignals einwirkt.

2. Bitsynchronisieranordnung nach Anspruch 1, wobei der Oszillator (3) einen Operationsverstärker (5) mit einem Kondensator (6) aufweist, der an den invertierenden Eingang angeschlossen ist zum Bilden eines Integrators, dessen Ausgang mit einer Flip-Flop-Schaltung mit Schwellen-Hysterese (11, 12) verbunden ist, die ein Zeitbasissignal in Form einer zweiwertigen Spannung liefert, die einem Ende eines ersten Widerstandes (9) zugeführt wird, dessen anderes Ende an den invertierenden Eingang des genannten Operationsverstärkers angeschlossen ist, dadurch gekennzeichnet, dass das genannte innere Dreieckspannungssignal an dem Ausgang des genannten Operationsverstärkers erhalten wird und dass die genannten Phasenkorrekturmittel durch einen zweiten Widerstand (25) gebildet werden, der zwischen dem genannten ersten Ausgang des genannten Übergangsdetektors und dem invertierenden Eingang des genannten Operationsverstärkers liegt und dessen Wert derselben Grössenordnung ist wie der des genannten ersten Widerstandes.

3. Bitsynchronisieranordnung nach Anspruch 2, wobei die Neigungen des genannten inneren Dreiecksignals in ihrem Absolutwert einander gleich sind, dadurch gekennzeichnet, dass die Werte des genannten ersten und zweiten Widerstandes (9 und 25) einander gleich sind, so dass der genannte Phasenkorrekturschritt in dem Phasenverzögerungssinn derselbe ist wie in dem Phasenvoreilsinn.

4. Bitsynchronisieranordung nach Anspruch 2 oder 3, für die ein Datendetektionssignal (DS) verfügbar ist, dadurch gekennzeichnet, dass sie ausserdem eine schnelle Synchronisieranordnung (4) aufweist, die durch eine potentiometrische Anordnung eines dritten (28), eines vierten (29) und eines fünften Widerstandes (31) gebildet ist, und zwar derart, dass die gemeinsamen Punkte zwischen dem dritten und dem vierten Widerstand einerseits (P) und zwischen dem vierten und dem fünften Widerstand andererseits (Q) durch Verbindungsmittel mit zwei steuerbaren Schaltern (32 und 33), die zwischen den genannten gemeinsamen Punkten und den genannten Enden des Kondensators angeordnet sind, wenigstens während der Dauer des ersten der genannten bei jeder Datenfolge für jeden Übergang des Datensignals auftretenden Impulse mit den Enden des genannten Kondensators verbunden sind, wobei die Werte des dritten, vierten und fünften Widerstandes (28, 29, 31) derart sind, dass während der Dauer des ersten Impuises eine völlige zwangsläufig Phasenrückstellung der Dreiecksignale und der Zeitbasissignale erzielt wird.

5. Bitsynchronisieranordnung nach Anspruch 4, wobei die ansteigende Flanke des Datendetektionssignals (DS) nach dem Erscheinen des genannten ersten Impulses auftritt, dadurch gekennzeichnet, dass der gemeinsame Steuereingang der genannten Schalter (32, 33) einerseits an einen zweiten Ausgang (B₁) des genannten Übergangsdetektors (1, 22) angeschlossen ist und andererseits mittels eines Inverters (35) und einer in der Sperrichtung geschalteten Diode (36) das genannte Datendetektionssignal zugeführt bekommt.

6. Bitsynchronisieranordnung nach Anspruch 4, wobei die ansteigende Flanke des Datendetektionssignals (DS) vor dem Erscheinen des genannten ersten Impulses auftritt, dadurch gekennzeichnet, dass der gemeinsame Steuereingang der genannten Schalter einerseits an einen zweiten Ausgang (B₁) des genannten Übergangsdetektors (1, 22) und andererseits mittels einer Diode (36) an den Q-Ausgang einer D-Flip-Flop-Schaltung (26) angeschlossen ist, wobei die genannte Flip-Flop-Schaltung mittels eines Inverters (35) an dem Nullrückstelleingang des Datendetektionssignals und an dem Taktimpulseingang ein drittes Ausgangssignal (S) des genannten Übergangsdetektors (1, 22) erhält.

7. Bitsynchronisieranordnung nach einem der vorstehenden Ansprüche, dadurch gekennzeichnet, dass das genannte Dreiecksignal einen in dem Absolutwert vergrösserten positiven Neigungswinkel und in dem Absolutwert verringerten negativen Neigungswinkel aufweist, so dass während einer Synchronisierung jede ansteigende Flanke des genannten Zeitbasissignals im wesentlichen in der Mitte des Bitintervalls auftritt.

8. Bitsynchronisieranordnung nach Anspruch 7, dadurch gekennzeichnet, dass die Änderungen der positiven und negativen Neigungswinkel des genannten Dreiecksignals im wesentlichen durch Änderung der Vorspannung des nicht-invertierenden Einganges des genannten als Integrator des Oszillators (3) geschalteten Operationsverstärkers (5) erhalten werden.

9. Bitsynchronisieranordnung nach einem der vorstehenden Ansprüche, dadurch gekennzeichnet, dass die verwendeten Schaltungen in CMOS- oder in zu CMOS kompatibler Technologie und/ oder in Dickschicht-Hybridschaltungstechnologie hergestellt sind.

FIG.10

FIG.1

FIG.2

FIG.4

FIG.3

FIG.5

FIG.6

FIG.7

FIG.8

0 092 879

FIG.9

FIG.13

23

FIG.11

FIG.12

FIG.14